# EUROPEAN PATENT APPLICATION

(11) **EP 4 002 410 A1**
(43) Date of publication of application: **25.05.2022**
(21) Application number: 20843519.8
(22) Date of filing: 29.05.2020
(51) Int. Cl.: H01H 9/02, F16B 5/08, B23K 26/21, H01H 11/00, H01H 19/04, B29C 65/16, H05K 5/00

(54) **ELECTRONIC COMPONENT AND MANUFACTURING METHOD THEREFOR**

(30) Priority: 19.07.2019 JP 2019133927
(71) Applicant: Nidec Copal Electronics Corporation, Shinjuku-ku Tokyo 160-0023 (JP)
(72) Inventor: KOMURO, Tadashi, Sano-shi, Tochigi 327-0104 (JP); KITSU, Syoto, Sano-shi, Tochigi 327-0104 (JP)
(74) Representative: Zech, Stefan Markus
(86) International application number: PCT/JP2020/021469
(87) International publication number: WO 2021/014762

(57) **Abstract**

A housing 11 includes a concave portion 11a in which components are to be accommodated. A cover 12 covers the concave portion. A first laser-welded portion 17a is provided along a circumference of the concave portion of the housing and fixes the cover to the housing. The cover 12 includes an opening 12b positioned inside of the first laser-welded portion 17a and corresponding to a part of the circumference of the concave portion of the housing.

## Description

### Technical Field

Embodiments of the present invention relate to a surface-mount type electronic component to be mounted on, for example, a surface of a printed board only by soldering and manufacturing method of the same.

### Background Art

A surface-mount type electronic component (hereinafter referred to as a surface-mount component) is, in general, placed on a solder paste applied to the printed board and then the solder paste is subjected to reflowing, whereby the component is soldered to the printed board. Thereafter, the printed board is washed in order that the flux and the like can be removed. At this time, the surface-mount component has a sealed structure in order to prevent the cleaning liquid from entering the inside of the surface-mount component.

When the solder is subjected to reflowing, the surface-mount component is exposed to a high temperature, and hence the air inside the component is expanded. Accordingly, a surface-mount component including a valve for discharging the expanded air inside the component is developed (see, for example, Patent Literature 1).

### Citation List

### Patent Literature

Patent Literature 1: JP H04-129113 A

### Summary of Invention

In recent years, there are also many cases where even a washable surface-mount component is actually used without being washed. In this case, the surface-mount component requires no airtightness.

Accordingly, it is conceivable that two types of components, i.e., a washable component having an airtight structure and component having no airtight structure and requiring no washing are prepared in advance, and the two types of components are used according to the use application. However, when both the component having the airtight structure and component having no airtight structure are to be prepared, it is necessary to make the shapes of the two types of components different from each other, and thus the number of components constituting the electronic component is increased and manufacturing cost is also increased.

Embodiments described herein aim to provide an electronic component making it possible to configure both airtight and non-airtight electronic components while preventing the number of components constituting the electronic component from being increased and also preventing the manufacturing cost from being increased, and manufacturing method of the electronic component.

An embodiment of an electronic component comprising a housing including a concave portion in which components are to be accommodated; a cover which covers the concave portion; and a first laser-welded portion provided along a circumference of the concave portion of the housing and fixing the cover to the housing, wherein the cover includes an opening positioned inside of the first laser-welded portion and corresponding to a part of the circumference of the concave portion of the housing.

An embodiment of a manufacturing method of an electronic component comprising providing, to a housing including a concave portion accommodating therein components, a cover for covering the concave portion; and forming a first laser-welded portion to fix the cover to a circumference of the concave portion of the housing by irradiating laser beam from the cover side, wherein the cover includes an opening positioned inside of the first laser-welding portion and corresponding to a part of the circumference of the concave portion of the housing.

### Brief Description of Drawings

FIG. 1 is a view showing an electronic component according to an embodiment and is a partially-exploded perspective view showing the state thereof before laser welding.
FIG. 2 is a view showing the electronic component according to this embodiment and is a perspective view showing the state thereof after laser welding.
FIG. 3 is a plan view of FIG. 2.
FIG. 4 is a plan view showing a state where a cover of FIG. 2 is removed.
FIG. 5 is a cross-sectional view along line V-V of FIG. 1.
FIG. 6 is a cross-sectional view along line VI-VI of FIG. 2.
FIG. 7 is a cross-sectional view showing an example of a laser welding device to be applied to the manufacture of the electronic component according to this embodiment.
FIG. 8 is a view showing the electronic component according to this embodiment and is a perspective view showing another state thereof after laser welding.
FIG. 9 is a cross-sectional view along line IX-IX of FIG. 8.

### Mode for Carrying Out the Invention

An Embodiment of the present invention will be described below with reference to the accompanying drawings. In the drawings, identical parts are denoted by identical reference symbols.

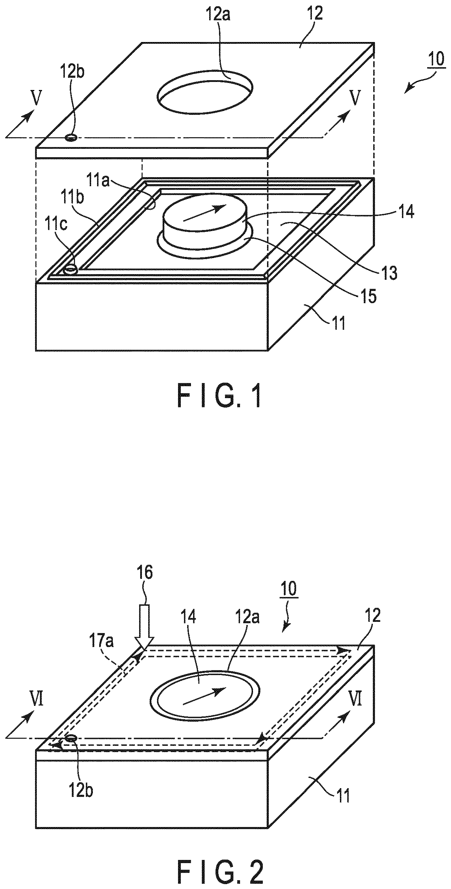

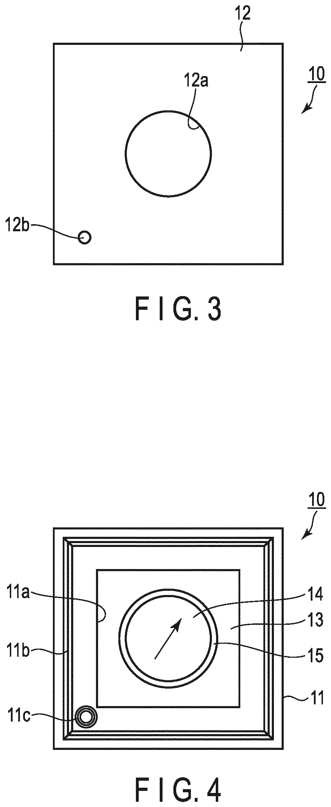

FIGS. 1 to 6 each show an electronic component 10 according to an embodiment. The electronic component 10 is a surface-mount component and, FIGS. 1 to 6 each show the electronic component 10 of a case where the component 10 is a dual in-line package (DIP) switch, e.g., a rotary switch. However, this embodiment is not limited to the switch, and can be applied to other electronic components.

The electronic component 10 includes, for example, a housing 11 functioning as a case, cover 12, switch mechanism 13, operation piece 14, and O-ring 15. The housing 11 is made of a meltable resin configured to absorb, for example, laser beam as will be described later, and includes a concave portion 11a in which the switch mechanism 13 can be accommodated.

Around the concave portion 11a of the housing 11, a protrusion 11b is provided. The protrusion 11b is melted by absorbing the laser beam irradiated thereon.

The protrusion 11b fixes the cover 12 to the housing 11 in the molten state. However, the protrusion 11b can also be omitted. That is, when it is possible to melt a part of the housing 11 around the concave portion 11a, sufficiently join the cover 12 to the housing 11, and maintain the airtightness inside the concave portion 11a, the protrusion 11b may not be provided.

Furthermore, at one corner part of the housing 11 around the concave portion 11a, for example, a ring-like protrusion 11c is provided. As will be described later, the protrusion 11c has a function of making the electronic component 10 a washable product having airtightness or product requiring no washing and having no airtightness. When it is possible to sufficiently join the housing 11 and cover 12 to each other, and maintain the airtightness at a portion between the housing 11 and cover 12, the protrusion 11c can also be omitted as in the case of the protrusion 11b.

The cover 12 is formed of a transparent resin, and an opening 12a is provided at a central part of the cover 12. The operation piece 14 is coupled to the switch mechanism 13, and is operated to turn on/off the switch mechanism 13.

The part between the operation piece 14 and cover 12 is made an airtight structure, and moisture and dust are thereby prevented from entering the inside of the housing 11. More specifically, between the circumference of the operation piece 14 and cover 12, for example, an O-ring formed of rubber is provided.

The configuration of the switch mechanism 13 is not the essentiality of this embodiment, and hence the specific configuration thereof is not shown. However, it is possible for the switch mechanism 13 to include a plurality of fixed contacts (not shown), common contact, moving contact coupled to the operation piece 14 and configured to electrically connect the fixed contact and common contact to each other, and the like.

Furthermore, at one corner part of the cover 12, an opening 12b is provided in such a manner as to correspond to the protrusion 11c. The diameter of the opening 12b is made approximately equivalent to the inner diameter of the ring-like protrusion 11c.

### (Manufacturing Method)

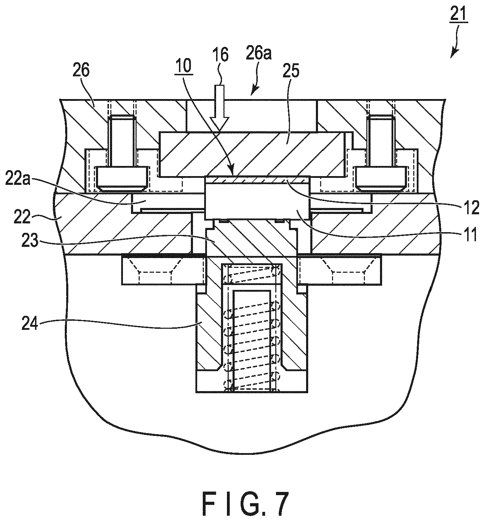

FIG. 7 shows an example of a laser welding device 21 to be applied to the manufacture of the electronic component according to this embodiment.

The laser welding device 21 includes a base table 22, first jig 23, pressing member 24, transparent plate 25, second jig 26, and the like. The base table 22 made of, for example, a metal includes an opening 22a, and first jig 23 made of a metal is arranged inside the opening 22a. The first jig 23 is placed on the pressing member 24.

The electronic component 10 is placed on the first jig 23. The transparent plate 25 made of, for example, glass is placed on the electronic component 10, and transparent plate 25 is held by the second jig 26 made of a metal. The second jig 26 includes an opening 26a having an area greater than the area of the top surface of the electronic component 10, and inner circumference of the opening 26a of the second jig 26 is kept in contact with the transparent plate 25. In this state, the first jig 23 is pressed toward the transparent plate 25 side by the pressing member 24, whereby the electronic component 10 interposed between the first jig 23 and transparent plate 25 is held by the jig 23 and plate 25.

As shown in FIG. 1, at the time of manufacture of the electronic component 10, first, the switch mechanism 13 and operation piece 14 are incorporated into the concave portion 11a of the housing 11. Subsequently, as shown in FIG. 2, the cover 12 is placed on the protrusion 11b, and concave portion 11a of the housing 11 is covered with the cover 12.

In the state where the cover 12 is placed on the housing 11 as described above, the electronic component 10 is set between the first jig 23 of the laser welding device 21 and transparent plate 25 as shown in FIG. 7. Accordingly, the cover 12 is pressed against the housing 11.

In this state, the electronic component 10 is irradiated with laser beam 16 from the opening 26a of the second jig 26 through the transparent plate 25. The irradiation position of the laser beam 16 is correspondent to the protrusion 11b provided inside the housing 11 and along the circumference of the housing 11 and, the laser beam 16 is moved along the protrusion 11b.

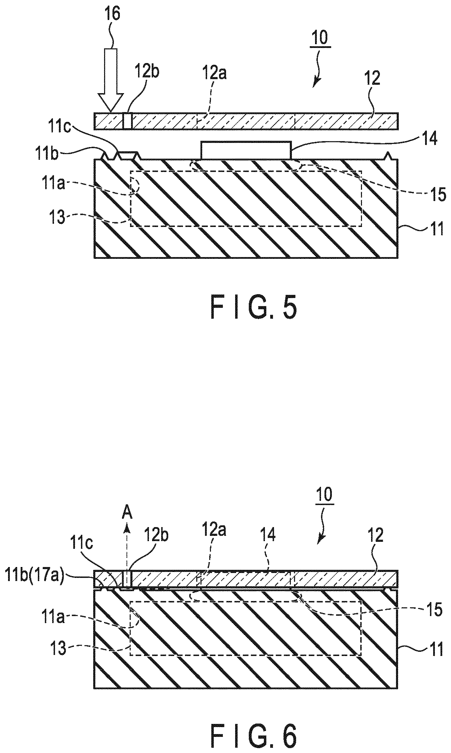

More specifically, as shown in FIG. 2 and FIG. 5, the protrusion 11b is irradiated with the laser beam 16 from the cover 12 side. The cover 12 of the electronic component 10 is formed of a transparent resin, and housing 11 is formed of a light-absorbing resin. Accordingly, the protrusion 11b is irradiated with the laser beam 16 passing through the cover 12, and protrusion 11b absorbs the laser beam 16 to thereby be melted. Accordingly, the cover 12 is welded to the housing 11 by the molten protrusion 11b.

The laser beam 16 is moved along the protrusion 11b throughout the entire circumference of the concave portion 11a. That is, the laser beam 16 is continuously applied to the part around the concave portion 11a throughout the entire circumference thereof and, the irradiation starting position and irradiation ending position are made coincident with each other.

Accordingly, as shown in FIG. 2, along the entire circumference of the concave portion 11a of the housing 11, a welded portion 17a which is a first laser-welded portion is continuously formed, and the entire circumference of the cover 12 is welded to the entire circumference of the housing 11 by the welded portion 17a.

In the state where the circumference of the cover 12 is welded to the circumference of the housing 11 as described above, the protrusion 11c is not welded to the cover 12. Accordingly, a very small gap is formed between the protrusion 11c and cover 12.

The electronic component 10 shown in FIG. 2 and FIG. 6 has a gap between the protrusion 11c and cover 12, and hence has no airtight structure and is a product requiring no washing. Accordingly, it is possible, at the time of, for example, the reflow, to discharge the expanded air inside the concave portion 11a of the housing 11 to the outside of the electronic component 10 from the opening 12b of the cover 12 through the gap between the cover 12 and protrusion 11c as shown in FIG. 6 by an arrow A.

Further, the gap between the cover 12 and protrusion 11c is very small. Accordingly, it is possible to prevent dust from entering the inside of the concave portion 11a from the gap.

On the other hand, when the washable electronic component 10 having the airtight structure is to be manufactured, the very small gap existing between the protrusion 11c and cover 12 is sealed up.

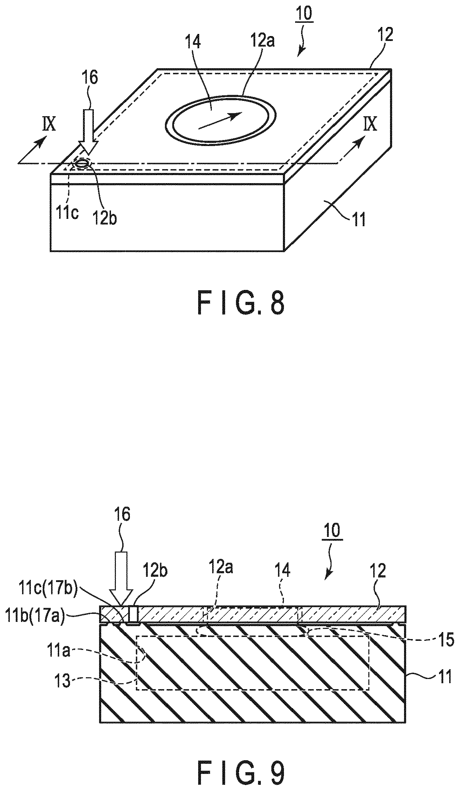

More specifically, as shown in FIG. 8 and FIG. 9, the laser beam is applied in a ring-like form along the protrusion 11c. That is, the laser beam 16 is continuously applied to the part around the protrusion 11c throughout the entire circumference thereof.

Accordingly, as shown in FIG. 9, a welded portion 17b which is a second laser-welded portion is continuously formed along the entire circumference of the protrusion 11c, and entire circumference of the protrusion 11c is welded to the circumference of the opening 12b of the cover 12 by the welded portion 17b. Accordingly, the concave portion 11a of the housing 11 is sealed up by the cover 12, and thus the washable electronic component 10 having the airtight structure is completed.

### (Advantageous Effects of Embodiment)

According to the embodiment described above, the housing 11 and cover 12 are welded to each other at the circumference of the concave portion 11a by using the laser beam 16, and the circumference of the opening 12b provided in the cover 12 and a part of the circumference of the concave portion 11a of the housing 11 corresponding to the circumference of the opening 12b are not welded to each other, whereby it is possible to manufacture the electronic component 10 having no airtightness and requiring no washing. Further, by welding the circumference of the opening 12b and circumference of the concave portion 11a to each other, it is possible to manufacture the washable electronic component 10 having airtightness. Owing to this, it is possible to manufacture both a washable electronic component and electronic component requiring no washing by using common components. Accordingly, it is possible to manufacture products having functions different from each other while preventing the number of components from being increased, and prevent the manufacturing cost from being increased.

In general, when both a washable electronic component and electronic component requiring no washing are to be manufactured by, for example, ultrasonic welding, it is necessary to partially change the structures of the electronic components or partially change the device configured to apply ultrasonic vibration.

When, for example, the structures of the electronic components are to be changed, it is necessary, with respect to the washable electronic component, not to provide the vent in the cover and, with respect to the electronic component requiring no washing, to provide the vent in the cover.

Further, when the structure of the device configured to apply ultrasonic vibration is to be changed, it is necessary, with respect to the washable electronic component, to prepare a component or components configured to apply the ultrasonic vibration to the entire circumference of the concave portion of the housing and, with respect to the electronic component requiring no washing, to prepare a component or components configured to apply the ultrasonic vibration to the circumference of the concave portion except for a part of the circumference thereof.

Accordingly, when the structures of the electronic components are to be changed, the number of components of each of the electronic components is increased and, when the structure of the device configured to apply the ultrasonic vibration is to be changed, the number of components of the manufacturing device is increased. Accordingly, in either case, the manufacturing cost of the products is increased.

Conversely, in the case of this embodiment, it is possible to manufacture the products having functions different from each other according to whether or not to apply the laser beam 16 to the circumference of the opening 12b, and hence it is possible to prevent the number of components of the electronic component or number of components of the manufacturing device from being increased, and prevent the manufacturing cost from being increased.

Further, according to this embodiment, only the electronic components 10 each including a minute gap between the circumference of the opening 12b and housing 11 and having no airtight structure are manufactured in advance and, when a washable electronic component is required, laser beam 16 is applied to the circumference of the opening 12b, whereby it is possible to manufacture the washable electronic component having the airtight structure. In this case, it is not necessary to prepare both the types of the washable electronic components and electronic components requiring no washing as a stock. Accordingly, it is possible to reduce the number of items in stock.

The present invention is not limited to the embodiments described above but the constituent elements of the invention can be modified in various manners without departing from the spirit and scope of the invention. Various aspects of the invention can also be extracted from any appropriate combination of a plurality of constituent elements disclosed in the embodiments. Some constituent elements may be deleted in all of the constituent elements disclosed in the embodiments. The constituent elements described in different embodiments may be combined arbitrarily.

## Claims

1. An electronic component **characterized by** comprising:
a housing including a concave portion in which components are to be accommodated;
a cover which covers the concave portion; and
a first laser-welded portion provided along a circumference of the concave portion of the housing and fixing the cover to the housing, wherein
the cover includes an opening positioned inside of the first laser-welded portion and corresponding to a part of the circumference of the concave portion of the housing.

2. The electronic component of claim 1, **characterized by** further comprising, at a part along a circumference of the opening, a second laser-welded portion which welds the cover and the housing to each other.

3. The electronic component of claim 1, **characterized in that**
the housing includes a protrusion at a position corresponding to the circumference of the opening.

4. A manufacturing method of an electronic component **characterized by** comprising:
providing, to a housing including a concave portion accommodating therein components, a cover for covering the concave portion; and
forming a first laser-welded portion to fix the cover to a circumference of the concave portion of the housing by irradiating laser beam from the cover side, wherein
the cover includes an opening positioned inside of the first laser-welding portion and corresponding to a part of the circumference of the concave portion of the housing.

5. The manufacturing method of an electronic component of claim 4, **characterized by** further comprising sealing up the opening by forming a second laser-welded portion which welds the cover and the housing to each other at a part along a circumference of the opening.

6. The manufacturing method of an electronic component of claim 4, **characterized in that**
the housing includes a protrusion at a position corresponding to a circumference of the opening.

7. The electronic component of claim 1, **characterized in that**
the circumference of the opening of the cover is fixed to the housing.

8. The manufacturing method of an electronic component of claim 6, **characterized by** comprising irradiating the protrusion with laser beam and melting the protrusion to thereby seal up the opening.
